# EUROPEAN PATENT SPECIFICATION

(11) **EP 0 833 956 B1**
(45) Date of publication and mention of the grant of the patent: **30.11.2005**
(21) Application number: 96917285.7
(22) Date of filing: 18.06.1996
(51) Int. Cl.: C23C 14/06, C23C 14/08, C23C 14/34, C23C 14/35, C23C 14/36

(54) **METHOD OF FORMING A SOLAR SELECTIVE SURFACE COATING**
VERFAHREN ZUM HERSTELLEN EINER SOLARSELEKTIVEN OBERFLÄCHENBESCHICHTUNG
METHODE DE FABRICATION D'UN REVETEMENT DE SURFACE SELECTIF SOLAIRE

(30) Priority: 19.06.1995 AU PN364195
(43) Date of publication of application: 08.04.1998
(73) Proprietor: THE UNIVERSITY OF SYDNEY, Sydney, New South Wales 2006 (AU)
(72) Inventor: ZHANG, Qi-Chu, Parramatta Road Sydney, NSW 2006 (AU); MILLS, David, Parramatta Road Sydney, NSW 2006 (AU)
(74) Representative: Jeck, Anton
(86) International application number: PCT/AU1996/000363
(87) International publication number: WO 1997/000335

(56) References cited:
- EP-A- 0 007 805
- EP-A- 0 104 870
- WO-A-91/16197
- AU-B- 538 944
- DE-A- 3 628 057
- DE-A- 4 221 864
- SATHIARAJ ET AL.: "Ni-Al2O3 cermet solar absorbers by RF planar magnetron sputtering for high temperature applications" SOLAR ENERGY MATERIALS., vol. 18, no. 6, June 1989 (1989-06), pages 343-356, XP000068655 ELSEVIER SCIENCE PUBLISHERS B.V. AMSTERDAM., NL

## Description

### FIELD OF THE INVENTION

This invention relates to a method of depositing a solar selective surface coating.

### BACKGROUND OF THE INVENTION

Most solar selective surface coatings currently employ metal-dielectric composites (which are known as cermets) as absorbers of solar energy. When deposited with appropriate layer thicknesses and metal volume fractions, the composites exhibit strong absorptive peaks in the main solar radiation region whilst remaining substantially transparent to thermal (infrared) radiation. The composites are deposited on infrared reflecting metal bases to form solar selective surface coatings.

Absorptive coatings that have been studied include direct current (dc) reactively sputtered chromium-oxygen, chromium-nitrogen, chromium-carbon, titanium-nitrogen, titanium-carbon, titanium-nitrogen-carbon, zirconium-nitrogen, zirconium-nitrogen-carbon, nickel-carbon, nickel-nitrogen, molybdenum-carbon, stainless steel-carbon and aluminium-nitrogen composites. Several of these composites have been employed as absorptive coatings on commercially produced collector elements, including dc reactively sputtered stainless steel-carbon and aluminium-nitrogen composites. However these composite coatings can be used only at low temperatures or at medium temperatures (up to about 350°C) because of their lack of thermal stability at high temperatures.

Absorptive coatings that do exhibit stability at higher temperatures include radio frequency (rf) sputtered metal-Al₂O₃ and metal-SiO₂ composites. Cermet material absorptive coatings that have been employed in commercially produced collector elements have been deposited as composites of dc sputtered Mo metal and rf sputtered Al₂O₃ and SiO₂ dielectric materials.

However, cermet coatings that employ rf sputtered dielectric materials are expensive to produce, both in terms of capital equipment and energy required for deposition. Also, difficulty is encountered in depositing cermets because of the potential of the dielectric material targets to crack due to poor thermal conductivity.

AU-5 38 944 shows a method of applying a solar selective coating in the form of a graded cermet coating.

### SUMMARY OF THE INVENTION

The invention may be defined as providing a method of forming a solar selective surface coating and which comprises the steps of:
(a) depositing an infrared reflective metal layer on a substrate by a non-reactive sputtering process, and
(b) depositing a solar energy absorptive coating in the form of a multi-layer cermet coating on the reflective metal layer.
The absorptive coating is deposited as a cermet which is formed by sputtering material simultaneously from first and second metal electrodes onto the reflective metal layer in the presence of at least one gas which is reactive with the metal from which the second electrode is formed and substantially non-reactive with the metal from which the first electrode is formed. The multi-layer coating is formed so that each layer has a refractive index which is different from the or each adjacent layer.

The invention may also be used in a solar collector element that comprises a tube through which a heat exchange fluid may be passed, a glass envelope surrounding the tube, an evacuated space defined by the tube and the envelope, and a solar selective surface coating as above defined deposited on the outer surface of the tube.

The tube of the solar collector element may be formed from metal or glass, and when formed from an appropriate metal the outer surface of the tube may constitute the infrared reflective layer of the solar selective surface coating. That is, in certain circumstances the solar absorptive coating may be deposited directly onto the outer surface of the collector element heat exchange tube.

The various forms of the present invention as above defined are characterised by a common feature, namely the co-deposition of materials from the first and second electrode metals in the presence of a gas which is reactive with the metal of one only of the electrodes in a manner so that a multi-layer cermet coating is formed in which each layer has a refractive index which is different from the or each adjacent layer.

### PREFERRED FEATURES OF THE INVENTION

The gas which is selected to provide for reactive sputtering of the cermet will be determined by the metals from which the first and second electrodes are formed. As indicated previously, the gas must be reactive with the second electrode metal, to form the dielectric component of the cermet, and substantially non-reactive with the first electrode metal. The gas may comprise a gas mixture (i.e., a mixture of two or more reactive gases) in an inert sputter supporting gas such as argon, but the reactive gas most preferably comprises nitrogen. When sputtering in the presence of nitrogen, oxygen may with advantage be absorbed in reactive sputtering of the second electrode metal to form the dielectric component.

When sputtering in the presence of nitrogen reactive gas, the metal which forms the metallic component of the cermet (i.e., the first electrode metal as referred to above) is preferably selected from tungsten, tungsten based alloys, stainless steel, nickel, nickel based alloys such as Inconel, Hastelloy and Monel, nickel-chromium alloys, platinum, iridium, osmium, ruthenium, rhodium, rhenium, molybdenum, molybdenum based alloys and gold. However, the first electrode metal most preferably comprises tungsten, particularly for applications where the absorptive coating is required to exhibit high temperature thermal stability.

When sputtering in the presence of oxygen reactive gas, the (first electrode) metal which forms the metallic component of the cermet is preferably selected from platinum, iridium, ruthenium, rhodium, rhenium and gold. However, in this case the first electrode metal most preferably comprises gold to minimise cost or platinum to maximise high temperature stability.

The metal which is reactively deposited to form the dielectric matrix (i.e., the second electrode metal as referred to above) is preferably selected from magnesium and aluminium. However, the second metal most preferably comprises aluminium in the interest of minimising cost.

The infrared reflective metal preferably is selected from aluminium, tungsten, copper, gold, silver and molybdenum. However, tungsten and molybdenum are most preferred for selective surface coatings that are required to operate at high temperature.

Deposition of the various metals, including non-reactive sputtering of the infrared reflective layer and co-deposition of the first and second metals in the presence of the reactive gas, is effected by direct current (dc) or alternating current (ac) magnetron sputtering. Radio frequency (rf) magnetron sputtering could be employed but the economic advantage of the present invention would then be lost or, at least, significantly diminished.

The absorptive coating may be deposited as a substantially homogeneous cermet, that is with the metal fraction uniformly distributed throughout the dielectric matrix for the full thickness of the coating.
Alternatively, the absorptive coating may be graded, such that the metal fraction of the cermet increases with depth of the coating. Also, each layer will have a thickness which is substantially transparent to infrared radiation but which provides for absorption of solar radiation by internal absorption and phase cancellation interference.

A preferred form of multi-layer absorptive coating comprises a two-layer cermet structure. The refractive index mismatch between the two adjacent layers may then be achieved by use of different cermet materials in the respective layers. However, it is preferred that the cermet component materials be the same in each layer and that the refractive index mismatch be achieved by depositing different metal volume fractions in adjacent layers. Again in the case of a two-layer absorptive coating, it is preferred that the inner layer be constituted by a high metal volume fraction cermet and that the outer layer be constituted by a low metal volume fraction cermet.

Whatever may be the structure of the absorptive surface coating, it is preferred that an anti-reflection surface be deposited upon the absorptive coating. The anti-reflective surface will be composed of a transparent dielectric material which enhances solar absorption and, in the case of the preferred form of the invention which comprises a W-ALN composite, the anti-reflection material will preferably be composed of reactively sputtered aluminium nitride, aluminium oxide or aluminium oxynitride.

An anti-diffusion layer may optionally be deposited between the absorptive coating and the infrared reflective layer and/or between the infrared reflective layer and the substrate in the complete solar selective surface coating. Also, an adhesion layer may optionally be deposited between the infrared reflective layer and the substrate.

The invention will be more fully understood from the following description of a preferred embodiment of a solar selective surface coating and a method of depositing such coating on an all-glass tubular solar collector element. The description is provided with reference to the accompanying drawings.

### BRIEF DESCRIPTION OF THE DRAWINGS

In the drawings -
Figure 1 shows an elevation view of a collector element,
Figure 2 shows on a very much enlarged scale a portion of the surface coating upon a part of the collector element,
Figure 3 shows a diagrammatic representation in elevation of a sputtering chamber in which deposition of the surface coating is effected, and
Figure 4 shows a plan view of the chamber that is illustrated in Figure 3.

### DETAILED DESCRIPTION OF THE INVENTION

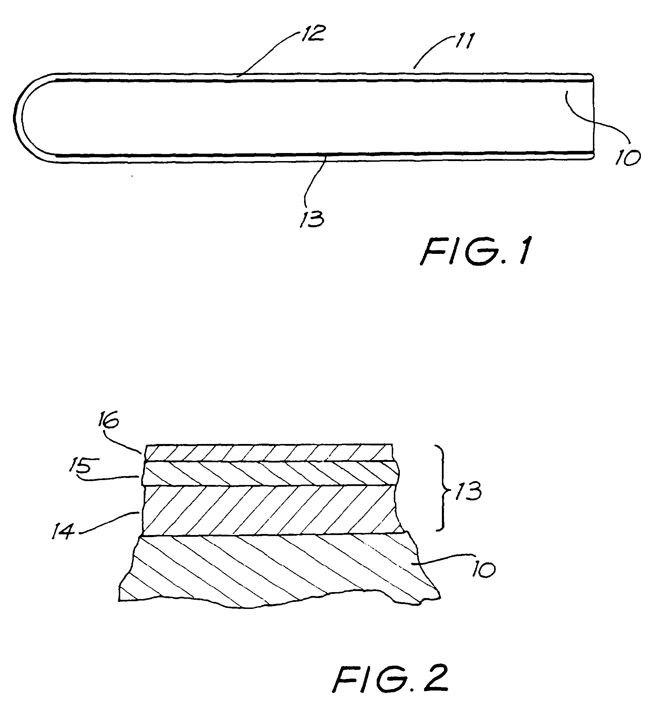

As illustrated in Figure 1, the collector element comprises an inner single-ended glass tube 10 which typically has an internal diameter in the order of 30 mm and an axial length in the order of 1000 to 2000 mm. The tube 10 is located within and is end-sealed to an outer glass tube 11, and the space 12 between the two tubes is evacuated. A thin film solar selective surface coating 13 is deposited on the outer surface of the inner tube 10.

The collector element would normally be mounted within a concentrator (not shown) and be connected in fluid circuit communication with a bank of similar elements. A heat exchange fluid is channelled into the inner tube 10 by way of a manifold (not shown), and thermal energy derived by absorption of solar radiation is conducted through the wall of the inner tube 10 to effect heating of the exchange fluid.

The surface coating 13 is illustrated in Figure 2 and comprises a three-layer structure. The inner layer 14 comprises an infrared reflective metal which is composed of a bright metal selected from those previously mentioned but which preferably comprises tungsten or molybdenum where the selective surface coating is to operated at a high temperature. The infrared reflective layer is deposited by a dc magnetron sputtering process, to be hereinafter described, to a thickness in the range of 100 to 400 nm and preferably to a thickness of about 300 nm. By depositing the reflective layer to such a thickness, infrared reflectance is enhanced.

The reflective layer 14 may be deposited as two sublayers, one being an anti-diffusion layer or an adhesion layer.

A solar energy absorptive coating 15 is deposited as a cermet on the infrared reflective layer 14. The cermet layer 15 is deposited to a thickness which is substantially transparent to infrared radiation but which facilitates absorption of solar radiation by internal absorption and phase cancellation interference. Thus, the cermet layer 15 has a thickness within the range 40 to 160 nm and preferably within the range 60 to 140 nm.

The cermet absorptive coating layer 15 comprises a composite of tungsten metal (W) and an aluminium nitride (AlN) dielectric, and the cermet is established by co-depositing material simultaneously from two metal electrodes, one of which is formed from tungsten and the other of which is formed from aluminium. The deposition is effected by a sputtering process in the presence of nitrogen gas. The nitrogen does not react significantly with the tungsten but does react strongly with the aluminium to form aluminium nitride during the sputtering process.

An anti-reflection surface layer 16 is deposited upon the absorptive coating 15 and is constituted by a transparent dielectric material which functions to enhance solar absorption. The surface layer 16 conveniently comprises reactively sputtered aluminium nitride but it might also comprise aluminium oxide or aluminium oxynitride, and the surface layer is typically deposited to a thickness in the range 60 to 100 nm.

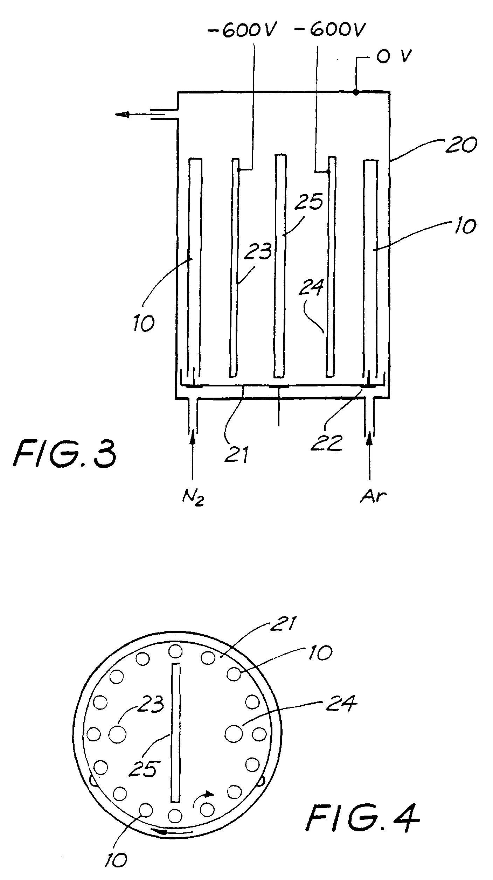

The complete surface coating as illustrated in Figure 2 may be deposited in the sputtering chamber as shown diagrammatically in Figures 3 and 4.

As illustrated in Figures 3 and 4, the sputtering chamber comprises a generally cylindrical chamber 20 in which a rotatable carrier 21 is located. The carrier is driven to rotate about the central axis of the chamber 20 with an angular velocity which is selectively variable within the range 3 to 10 revolutions per minute (rpm). The carrier 21 supports a plurality of the glass tubes 10 on which the selective surface coating 13 is to be deposited and each of the tubes is supported by a rotatable mandrel 22 which is driven to cause the tube to rotate about its own axis with an angular velocity in the range 30 to 70 rpm. The tubes 10 are positioned around the circumference of a circle having a diameter in the order of 1000 mm and the chamber 20 has a height sufficient to receive the 1000 to 2000 mm long tubes.

Two tubular metal target electrodes 23 and 24 are positioned diametrically about the centre axis of the sputtering chamber 20 and extend parallel to the axis of the chamber. The two electrodes are separately and selectively connected as cathodes to a power supply (not shown) and when so connected are maintained at a potential in the order of -600 volts. The wall of the chamber 20 is connected to the power supply to form an anode and is maintained at a potential of +600 volts relative to the cathodes, that is at earth (zero) potential.

Although not shown in Figures 3 and 4, the tubular target electrodes 23 and 24, forming the cathodes, would normally be connected to a supply of coolant fluid. Also, the target electrodes 23 and 24 are separated by a water cooled earth screen 25 for the purpose of preventing inter-contamination of the electrodes.

A magnetic field in the order of 0.03 Tesla is established by electromagnets or periodically placed permanent magnets (not shown) which are positioned to extend in a direction approximately parallel to the target electrodes 23 and 24.

As is apparent from Figure 3, during rotation of the carrier 21 the glass tubes 10 are positioned between the target cathodes 23, 24 and the surrounding wall of the chamber 20. The glass tubes are thus exposed periodically to material that is sputtered from the target cathodes 23 and 24 as the material moves radially outwardly toward the surrounding chamber 20.

The target electrodes 23 and 24 are respectively formed from tungsten and aluminium. Metal is sputtered from the tungsten electrode 23 to form the infrared reflective layer 14 of the surface coating and, also, to form the metal fraction within the cermet layer 15 of the coating. Material is sputtered from the aluminium electrode 24 to form the dielectric fraction within the cermet layer 15.

In an alternative arrangement, metal might be sputtered from the aluminium element 23 to form the infrared reflective coating 14, particularly where high temperature thermal stability is not so important. As a further possible alternative, a third electrode, for example a copper electrode or a molybdenum electrode might be located within the chamber and be employed as a target electrode during deposition of the infrared reflective layer 14.

In forming the complete solar selective surface coating 13 on the tube 10, the chamber 20 is evacuated to a level in the order of 1.3×10⁻⁴-1.3-10⁻³ Pa, (10⁻⁶ to 10⁻⁵ Torr). Argon gas is then admitted to establish a pressure of 0.13 Pa (10⁻³ Torr) and power is supplied to the tungsten electrode 23. Non-reactive dc magnetron sputtering occurs and tungsten is deposited substantially uniformly along the full length of the tubes 10. Sputtering is maintained for a time sufficient to achieve a coating thickness in the order of 300 nm. Each of the tubes 10 is rotated about its own axis and the carrier 21 is rotated about the chamber axis during the whole time that coating of the tubes is proceeding.

Having deposited the infrared reflective layer 14, the cermet layer 15 is formed by co-depositing material from both the tungsten and aluminium target cathodes 23 and 24 in the presence of a gas mixture containing both argon and nitrogen.

As stated previously, the tungsten is deposited as a metal fraction in the cermet composite, and the aluminium reacts with the nitrogen to form an aluminium nitride dielectric fraction in the cermet.

Tungsten is chosen as the preferred metal for use in the cermet layer 15 because it exhibits good oxidation resistance, is stable at room temperature and does not normally react with nitrogen gas at any temperature. However, when sputtering tungsten in a gas mixture which includes reactive nitrogen gas a small fraction of tungsten nitride may be formed and, in order to sputter a substantially pure tungsten metal phase into the cermet composite, the nitrogen partial pressure in the region of the tungsten cathode should be kept as low as possible.

In contrast with the nitriding resistance of tungsten, the chemical reactivity of aluminium with nitrogen is very high and it is relatively easy to nitride aluminium in the presence of nitrogen gas. Thus, aluminium sputtered from the cathode 24 is reactively sputtered with the nitrogen gas and a transition from the metal phase to the dielectric phase occurs as the nitrogen partial pressure is increased. With a relatively low nitrogen gas flow, the ratio of aluminium to nitrogen is dependent upon the gas flow and aluminium in the metal phase will be deposited in the cermet. In order to deposit nearly stoichiometric aluminium nitride, a nitrogen gas flow rate is employed, using a gas flow controller (not shown), to establish a partial pressure of 1.3×10⁻² Pa (10⁻⁴ Torr).

The co-deposition sputtering process is maintained in the presence of the nitrogen gas for such period of time as is required to establish a layer thickness in the order of 60 to 140 nm.

Finally, power to the tungsten cathode 23 is turned off and metal that is sputtered from the aluminium cathode 24 is reacted with the nitrogen to form a substantially pure aluminium nitride layer upon the cermet layer and so to form the anti-reflective layer 16. This process is maintained for sufficient time to establish a layer having a thickness in the order of 60 to 100 nm.

## Claims

1. A method of forming a solar selective surface coating which comprises the steps of -
(a) depositing an infrared reflective metal layer on a substrate by a non-reactive sputtering process and
(b) depositing a solar energy absorptive coating in the form of a multi-layer cermet coating on the reflective metal layer; wherein each layer of the multi-layer cermet coating is formed by sputtering material simultaneously from first and second metal electrodes onto the reflective metal layer in the presence of at least one gas which is reactive with the metal from which the second electrode is formed and substantially non-reactive with the metal from which the first electrode is formed, and wherein each each layer has a refractive index which is different from the or each adjacent layer.

2. The method as claimed in claim 1 wherein adjacent ones of the multi-layer cermet coatings are deposited with different metal fractions.

3. The method as claimed in claim 2 wherein there are two only cermet coating layers, and wherein the inner layer cermet coating is deposited with a higher metal fraction than the outer layer cermet coating.

4. The method as claimed in claim 1 wherein the metal from which the first electrode is formed is selected from the group comprising tungsten, tungsten based alloys, stainless steel, nickel, nickel based alloys, nickel-chromium alloys, platinum, iridium, osmium, ruthenium, rhodium, rhenium, molybdenum, molybdenum based alloys and gold.

5. The method as claimed in claim 4 wherein the cermet is formed by sputtering the metal from the first and second electrodes in the presence of nitrogen gas and an inert sputter supporting gas.

6. The method as claimed in claim 1 wherein the metal from which the first electrode is formed is selected from the group comprising platinum, iridium, ruthenium, rhodium, rhenium and gold.

7. The method as claimed in claim 6 wherein the cermet is formed by sputtering the metal from the first and second electrodes in the presence of oxygen and an inert sputter supporting gas.

8. The method as claimed in any one of claims 1 to 7 wherein the metal from which the second electrode is formed is selected from the group comprising aluminium and magnesium.

9. The method as claimed in claim 1 wherein the reflective metal layer is deposited as a metal selected from the group comprising aluminium, tungsten, copper, gold, silver and molybdenum.

10. The method as claimed in claim 1 wherein the metal from which the first electrode is formed comprises tungsten which is deposited to form both the infrared reflective metal layer and a metallic component of the cermet wherein the metal from which the second electrode is formed comprises aluminium, and wherein the cermet is formed by sputtering the metal from the first and the second electrodes in the presence of nitrogen gas and an inert sputter supporting gas.

11. The method as claimed in claim 1 wherein the deposition of the infrared reflective metal layer and deposition of the cermet are effected by direct current or alternating current magnetron sputtering.

12. The method as claimed in claim 1 wherein the solar energy absorptive coating is deposited with a metal fraction of the cermet distributed substantially uniformly throughout a dielectric matrix of the cermet for substantially the full thickness of the coating.

13. The method as claimed in claim 1 or claim 2 wherein the solar energy absorptive coating is deposited to a thickness which is substantially transparent to infrared radiation and which provides for absorption of solar radiation by internal absorption and phase cancellation interference.

14. The method as claimed in claim 13 wherein the solar energy absorptive coating is deposited to a thickness within the range 40 to 160 nm.

15. The method as claimed in claim 1 wherein the infrared reflective metal layer is deposited to a thickness in the range 100 to 400 nm.

16. The method as claimed in claim 1 wherein an anti-reflection surface layer in the form of a transparent dielectric material is deposited upon the solar energy absorptive coating.

17. The method as claimed in claim 16 as a composite selected from the group comprising aluminium nitride, aluminium oxide and aluminium oxynitride.

## Patentansprüche

1. Verfahren zum Herstellen einer solarselektiven Oberflächenbeschichtung mit folgenden Schritten:
(a) eine Infrarotlicht reflektierende Metallschicht wird durch einen nichtreaktiven Vakuumzerstäubungsprozess auf einem Substrat abgelagert und
(b) eine Solarenergie absorbierende Schicht wird in Form einer vielschichtigen Cermetschicht auf der reflektierenden Metallschicht abgelagert,
**dadurch gekennzeichnet,**
**dass** jede Schicht der vielschichtigen Cermetschicht durch das Vakuumzerstäubungsmaterial gleichzeitig von einer ersten Metallelektrode und von einer zweiten Metallelektrode zu der reflektierenden Metallschicht in Gegenwart von mindestens einem Gas gebildet wird, das mit demjenigen Metall reagiert, aus dem die zweite Elektrode besteht, und das mit demjenigen Metall nicht reagiert, aus dem die erste Elektrode besteht, und dass jede Schicht einen Brechungsindex aufweist, der zu dem der oder jeder benachbarten Schicht unterschiedlich ist.

2. Verfahren nach Anspruch 1,
**dadurch gekennzeichnet,**
**dass** die benachbarten Schichten der vielschichtigen Cerrmetschichten mit unterschiedlichen Korngrößenklassen des Metalls abgelagert werden.

3. Verfahren nach Anspruch 2,
**dadurch gekennzeichnet,**
**dass** nur zwei Cermetschichten vorgesehen sind und dass die innere Cermetschicht mit einer höheren Korngrößenklasse des Metalls als die äußere Cermetschicht abgelagert ist.

4. Verfahren nach Anspruch 1,
**dadurch gekennzeichnet,**
**dass** dasjenige Metall, aus dem die erste Elektrode besteht, aus der Gruppe ausgewählt ist, die Wolfram, Wolframlegierungen, rostfreien Stahl, Nickel, Nickellegierungen, Nickel-Chrom-Legierungen, Platin, Iridium, Osmium, Ruthenium, Rhodium, Rhenium, Molybdän, Molybdänlegierungen und Gold enthält.

5. Verfahren nach Anspruch 4,
**dadurch gekennzeichnet,**
**dass** das Cermet durch Vakuumzerstäubung des Metalls von der ersten Elektrode und der zweiten Elektrode in Gegenwart von Stickstoffgas und einem inaktiven Zerstäubungsträgergas gebildet wird.

6. Verfahren nach Anspruch 1,
**dadurch gekennzeichnet,**
**dass** dasjenige Metall, aus dem die erste Elektrode besteht, aus der Gruppe ausgewählt ist, die Platin, Iridium, Ruthenium, Rhodium, Rhenium und Gold enthält.

7. Verfahren nach Anspruch 6,
**dadurch gekennzeichnet,**
**dass** das Cermet durch Zerstäuben des Metalls von der ersten Elektrode und der zweiten Elektrode in Gegenwart von Sauerstoffgas und einem inaktiven Zerstäubungsträgergas gebildet wird.

8. Verfahren nach einem der Ansprüche 1 bis 7,
**dadurch gekennzeichnet,**
**dass** dasjenige Metall, aus dem die zweite Elektrode besteht, aus der Gruppe ausgewählt ist, die Aluminium und Magnesium enthält.

9. Verfahren nach Anspruch 1,
**dadurch gekennzeichnet,**
**dass** die reflektierende Metallschicht als Metall abgelagert ist, das aus der Gruppe ausgewählt ist, die Aluminium, Wolfram, Kupfer, Gold, Silber und Molybdän enthält.

10. Verfahren nach Anspruch 1,
**dadurch gekennzeichnet,**
**dass** dasjenige Metall, aus dem die erste Elektrode besteht, Wolfram aufweist, das derart abgelagert wird, dass es sowohl die Infrarotlicht reflektierende Metallschicht als auch eine metallische Komponente des Cermets bildet, dass dasjenige Metall, aus dem die zweite Elektrode besteht, Aluminium aufweist und dass das Cermet durch Zerstäuben des Metalls von der ersten Elektrode und der zweiten Elektrode in Gegenwart von Stickstoffgas und einem inaktiven Zerstäubungsträgergas gebildet wird.

11. Verfahren nach Anspruch 1,
**dadurch gekennzeichnet,**
**dass** die Ablagerung der Infrarotlicht reflektierenden Schicht und die Ablagerung des Cermets durch Zerstäuben mit Hilfe eines mit Gleichstrom oder Wechselstrom betriebenen Magnetron bewirkt werden.

12. Verfahren nach Anspruch 1,
**dadurch gekennzeichnet,**
**dass** die die Solarenergie absorbierende Schicht mit einer Metallkorngrößenklasse des Cermets abgelagert wird, das im Wesentlichen gleichmäßig über eine dielektrische Matrix des Cermets für im Wesentlichen die volle Schichtstärke verteilt ist.

13. Verfahren nach Anspruch 1 oder 2,
**dadurch gekennzeichnet,**
**dass** die die Solarenergie absorbierende Schicht in einer Stärke abgelagert wird, die für die Infrarotstrahlung im Wesentlichen durchlässig ist und die für eine Absorption der Solarstrahlung sorgt, die durch eine innere Absorption und durch eine Phasenunterdrückungswirkung hervorgerufen wird.

14. Verfahren nach Anspruch 13,
**dadurch gekennzeichnet,**
**dass** die die Solarenergie absorbierende Schicht in einer Stärke abgelagert wird, die im Bereich von 40-160nm liegt.

15. Verfahren nach Anspruch 1,
**dadurch gekennzeichnet,**
**dass** die das Infrarotlicht reflektierende Metallschicht in einer Stärke abgelagert wird, die im Bereich von 100-400nm liegt.

16. Verfahren nach Anspruch 1,
**dadurch gekennzeichnet,**
**dass** eine nicht reflektierende Oberflächenschicht in Form eines durchlässigen, dielektrischen Materials auf der die Solarenergie absorbierenden Schicht abgelagert ist.

17. Verfahren nach Anspruch 16,
**dadurch gekennzeichnet,**
**dass** die Oberflächenschicht eine Zusammensetzung ist, die aus der Gruppe ausgewählt ist, die Aluminiumnitrid, Aluminiumoxid und Aluminiumoxynitrid enthält.

## Revendications

1. Procédé de fabrication d'un revêtement de surface sélectif solaire qui comprend les étapes consistant à :
(a) déposer une couche métallique réfléchissant les rayons infrarouges sur un substrat par un procédé de pulvérisation non-réactif et
(b) déposer un revêtement absorbant l'énergie solaire sous la forme d'un revêtement de cermet multicouche sur la couche métallique réfléchissante ; dans lequel chaque couche du revêtement de cermet multicouche est formée par pulvérisation cathodique de matière simultanée à partir de la première et de la seconde électrodes métalliques sur la couche métallique réfléchissante en présence d'au moins un gaz qui réagit avec le métal à partir duquel la seconde électrode est formée et qui essentiellement ne réagit pas avec le métal à partir duquel la première électrode est formée, et dans lequel chaque couche a un indice de réfraction qui est différent de la ou de chaque couche adjacente.

2. Procédé selon la revendication 1, dans lequel les couches adjacentes des revêtements de cermet multicouche sont déposées avec des fractions métalliques différentes.

3. Procédé selon la revendication 2 dans lequel il n'y a seulement que deux couches de revêtement de cermet, et dans lequel le revêtement de cermet de la couche interne est déposé avec une fraction métallique plus élevée que le revêtement de cermet de la couche externe.

4. Procédé selon la revendication 1 dans lequel le métal à partir duquel la première électrode est formée est choisi dans le groupe comprenant le tungstène, les alliages à base de tungstène, l'acier inoxydable, le nickel, les alliages à base de nickel, les alliages à base de nickel-chrome, le platine, l'iridium, l'osmium, le ruthénium, le rhodium, le rhénium, le molybdène, les alliages à base de molybdène et l'or.

5. Procédé selon la revendication 4 dans lequel le cermet est formé par pulvérisation cathodique du métal à partir de la première et de la seconde électrodes en présence d'azote gazeux et d'un gaz porteur de pulvérisation inerte.

6. Procédé selon la revendication 1 dans lequel le métal à partir duquel la première électrode est formée est choisi dans le groupe comprenant le platine, l'iridium, le ruthénium, le rhodium, le rhénium et l'or.

7. Procédé selon la revendication 6 dans lequel le cermet est formé par pulvérisation cathodique du métal à partir de la première et de la seconde électrodes en présence d'oxygène et d'un gaz porteur de pulvérisation inerte.

8. Procédé selon l'une quelconque des revendications 1 à 7 dans lequel le métal à partir duquel la seconde électrode est formée est choisi dans le groupe comprenant l'aluminium et le magnésium.

9. Procédé selon la revendication 1 dans lequel la couche métallique réfléchissante est déposée sous forme d'un métal choisi dans le groupe comprenant l'aluminium, le tungstène, le cuivre, l'or, l'argent et le molybdène.

10. Procédé selon la revendication 1 dans lequel le métal à partir duquel la première électrode est formée comprend du tungstène lequel est déposé pour former à la fois la couche métallique réfléchissant les rayons infrarouges et un composant métallique du cermet dans lequel le métal à partir duquel la seconde électrode est formée comprend de l'aluminium, et dans lequel le cermet est formé par pulvérisation cathodique du métal à partir de la première et de la seconde électrodes en présence d'azote gazeux et d'un gaz porteur de pulvérisation inerte.

11. Procédé selon la revendication 1 dans lequel la déposition de la couche métallique réfléchissant les rayons infrarouges et la déposition du cermet sont effectuées par pulvérisation magnétron à courant continu ou alternatif.

12. Procédé selon la revendication 1 dans lequel le revêtement absorbant l'énergie solaire est déposé avec une fraction métallique du cermet distribuée essentiellement de manière uniforme au travers d'une matrice diélectrique du cermet pour essentiellement l'épaisseur totale du revêtement.

13. Procédé selon la revendication 1 ou la revendication 2 dans lequel le revêtement absorbant l'énergie solaire est déposé suivant une épaisseur qui est essentiellement transparente aux rayons infrarouges et qui assure l'absorption du rayonnement solaire par absorption interne et interférence par annulation de phase.

14. Procédé selon la revendication 13 dans lequel le revêtement absorbant l'énergie solaire est déposé suivant une épaisseur dans la plage de 40 à 160 nm.

15. Procédé selon la revendication 1 dans lequel la couche métallique réfléchissant les rayons infrarouges est déposée suivant une épaisseur dans la plage de 100 à 400 nm.

16. Procédé selon la revendication 1 dans lequel une couche de surface anti-reflet sous la forme d'un matériau diélectrique transparent est déposée sur le revêtement absorbant l'énergie solaire.

17. Procédé selon la revendication 16 comme un composite choisi dans le groupe comprenant le nitrure d'aluminium, l'oxyde d'aluminium et oxynitrure d'aluminium.
